(19) Europäisches Patentamt / European Patent Office / Office européen des brevets

(11) **EP 4 395 003 A1**

(12) **EUROPEAN PATENT APPLICATION**

(43) Date of publication:
**03.07.2024 Bulletin 2024/27**

(21) Application number: **23209054.8**

(22) Date of filing: **10.11.2023**

(51) International Patent Classification (IPC):
**H01M 10/48** (2006.01)     **H01M 10/44** (2006.01)
**H01M 50/209** (2021.01)     **H01M 50/569** (2021.01)
**G01R 31/387** (2019.01)     **G01R 31/392** (2019.01)
**G01R 31/396** (2019.01)     **H01M 50/204** (2021.01)
**H01M 10/42** (2006.01)

(52) Cooperative Patent Classification (CPC):
**H01M 10/482; G01R 31/36; H01M 10/441;**
**H01M 10/484; H01M 10/488; H01M 50/209;**
**H01M 50/569;** G01R 31/392; H01M 10/425;
H01M 50/204; H01M 2010/4271

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **26.12.2022   JP 2022208370**

(71) Applicant: **Prime Planet Energy & Solutions, Inc.**
**Chuo-ku**
**Tokyo**
**103-0022 (JP)**

(72) Inventors:
• **SOEJIMA, Takanori**
  **Tokyo, 103-0022 (JP)**
• **FUJIMAKI, Hisataka**
  **Tokyo, 103-0022 (JP)**

(74) Representative: **Kuhnen & Wacker**
**Patent- und Rechtsanwaltsbüro PartG mbB**
**Prinz-Ludwig-Straße 40A**
**85354 Freising (DE)**

(54) **BATTERY MODULE**

(57) The present disclosure provides a battery module that can properly suppress a high rate deterioration of a secondary battery and further that can maintain a charge efficiency equal to or more than a certain level. The herein disclosed battery module 1 includes a battery device 100 including a secondary battery 110 in which an electrode body and an electrolytic solution are accommodated inside a battery case, and includes a control device 200 that is configured to control a charge and discharge of the battery device 100. Then, the control device 200 includes an increase amount measurer 210 that is configured to measure an increase amount $L_\Delta$ of an excess electrolytic solution of the secondary battery 110 for a charge, and includes a current value corrector 220 that is configured to perform a current correcting control in which a current value of a charge current is corrected with respect to the battery device 100 based on the increase amount $L_\Delta$ of the excess electrolytic solution. By doing this, it is possible to continue the charge while the current value is corrected according to an extent of the high rate deterioration, and thus it is possible to properly suppress the high rate deterioration of the secondary battery so as to maintain the charge efficiency equal to or more than a certain level.

FIG.1

## Description

BACKGROUND

1. Technical Field

A technique disclosed herein relates to a battery module.

2. Description of the Related Art

A secondary battery, such as lithium ion secondary battery, has been widely used in various fields, such as electric vehicle and portable terminal. This secondary battery is mounted on an external equipment (electric vehicle, portable terminal, or the like) generally in a state of being a battery module connected to a control device. This control device suitably controls a charge and discharge of the secondary battery. In addition, the secondary battery has, for example, a configuration of accommodating an electrolytic solution and an electrode body in a battery case. Regarding the secondary battery having the configuration described above, the electrolytic solution is osmosed to an inside (electrode gap between a positive electrode and a negative electrode) of the electrode body. In addition, regarding this type of secondary battery, an excess electrolytic solution not osmosed to an inside of the electrode body might be caused at an outside of the electrode body (between the electrode body and the battery case). By doing this, it is possible to supply the electrolytic solution to the inside of the electrode body when a shortage of the electrolytic solution inside the electrode body is caused.

Anyway, on the secondary battery having the above described configuration, a degradation phenomenon (high rate deterioration) could be caused in which a battery resistance for a rapid charge is increased drastically. This high rate deterioration is caused by the electrolytic solution inside the electrode body flowing out due to an expansion of an electrode (particularly, negative electrode) for the rapid charge. With respect to this issue, a control device (ECU) described in JP2021-180122 is configured to suppress a progress of the high rate deterioration. Particularly, the control device described in JP2021-180122 calculates a high rate deterioration amount based on a deviation of a salinity distribution inside the electrode body. Then, this control device is configured to stop a charge when a high rate deterioration amount becomes more than an allowable value while the charge is performed, and to restart the charge when the high rate deterioration amount becomes less than the allowable value while the charge is stopped. Incidentally, the technique described in Patent Document 1 calculates the deviation of the salinity distribution based on a current value of the secondary battery.

SUMMARY

Anyway, in response to a recent spread of an electric vehicle and a portable terminal, a request for enhancing a performance of the battery module is increased. With respect to this issue, it is difficult regarding the technique described in JP2021-180122 to maintain a charge efficiency being high, because the technique stops the charge on each occasion that the high rate deterioration is detected. The herein disclosed technique has been made in view of the problem described above, and an object is to provide the battery module that can properly suppress the high rate deterioration of the secondary battery and further that can maintain a charge efficiency equal to or more than a constant level.

In order to solve the problem described above, the herein disclosed technique provides the battery module having a configuration described below.

The herein disclosed battery module includes a battery device including a secondary battery in which an electrode body and an electrolytic solution are accommodated inside a battery case, and includes a control device configured to control a charge and discharge of a battery device. Then, a control device includes an increase amount measurer configured to measure an increase amount $L_\Delta$ of an excess electrolytic solution of a secondary battery for a charge, and includes a current value corrector configured to perform a current correcting control for correcting a current value of a charge current with respect to a battery device, based on an increase amount $L_\Delta$ of an excess electrolytic solution.

As described above, the herein disclosed battery module measures the increase amount $L_\Delta$ of the excess electrolytic solution for the charge. This "increase amount $L_\Delta$ of the excess electrolytic solution" represents an amount of the electrolytic solution having flown out to an outside of the electrode body due to the expansion of the electrode during the charge. In other words, it is possible to consider that, in a state where this increase amount $L_\Delta$ of the excess electrolytic solution is small, the high rate deterioration progresses little. On the other hand, it is possible to consider that, in a state where the increase amount $L_\Delta$ of the excess electrolytic solution becomes large, the high rate deterioration progresses. Then, the current value corrector of the battery module having the configuration described above performs the current correcting control based on the increase amount $L_\Delta$ of the excess electrolytic solution. By doing this, it is possible to continue the charge while the current value is corrected according to the extent of the high rate deterioration, and thus it is possible to properly suppress the high rate deterioration of the secondary battery and further to maintain the charge efficiency equal to or more than a certain level.

Additionally, in a suitable aspect of the battery module disclosed herein, a control device further includes a start deciding circuit that is configured to instruct a current value corrector to start a current correcting control when an increase amount $L_\Delta$ of an excess electrolytic solution exceeds a predetermined threshold $L_T$. Regarding the battery module having the configuration described above, the current correcting control is not performed under a situation where the high rate deterioration is caused little. By doing this, it is possible to maintain the charge efficiency being further high.

Additionally, in a suitable aspect of the battery module disclosed herein, an increase amount measurer includes a liquid amount obtainer configured to obtain a first liquid amount $L_1$ corresponding to a liquid amount of an excess electrolytic solution with a predetermined first SOC, a second liquid amount $L_2$ corresponding to a liquid amount of an excess electrolytic solution with a second SOC being a higher SOC than a first SOC, and a total liquid amount $L_T$ corresponding to a total amount of an electrolytic solution existing inside a battery case, and includes an increase amount calculator configured to calculate an increase amount $L_\Delta$ of an excess electrolytic solution based on a following Formula (1). By doing this, it is possible to obtain the further accurate increase amount $L_\Delta$ of the excess electrolytic solution.

$$L_\Delta = (L_2 - L_1)/L_T \qquad (1)$$

Additionally, in a suitable aspect of the battery module disclosed herein, a first SOC is set within a range from 10% to 20%. By setting such a low SOC area as the start period of measurement, it is possible to obtain the further accurate increase amount $L_\Delta$ of the excess electrolytic solution.

Additionally, a suitable aspect of the battery module disclosed herein further includes an X-ray image capturing apparatus that is configured to capture an X-ray transmission image of a secondary battery. Then, the liquid amount obtainer includes an image capture instruction circuit configured to instruct an X-ray image capturing apparatus so as to capture an X-ray transmission image, and includes an image analyzer configured to measure a liquid amount of an excess electrolytic solution based on an image analysis for an X-ray transmission image. By doing this, it is possible to directly measure the liquid amount of the excess electrolytic solution, and thus it is possible to obtain the further accurate increase amount $L_\Delta$ of the excess electrolytic solution.

Additionally, in a suitable aspect of the battery module disclosed herein, an image analyzer is configured to set a measurement line along a side surface of a battery case on an area between an electrode body and a battery case, and the image analyzer is configured to analyze changes of luminance on a measurement line, so as to measure a liquid amount of an excess electrolytic solution. By doing this, it is possible to further accurately measure the liquid amount of the excess electrolytic solution.

Additionally, in a suitable aspect of the battery module disclosed herein, an increase amount measurer further includes an angle detector that is configured to detect a tilt angle $\theta$ of a secondary battery. Then, an image capture instruction circuit in the aspect described above instructs an X-ray image capturing apparatus to capture an X-ray transmission image when a tilt angle $\theta$ exceeds a predetermined capture angle $\theta_T$. By doing this, it is possible to further accurately measure the liquid amount of the excess electrolytic solution.

Additionally, in a suitable aspect of the battery module disclosed herein, a battery case is formed with aluminum or resin. By doing this, it is possible to easily obtain the clear X-ray transmission image.

Additionally, in a suitable aspect of the battery module disclosed herein, a battery device includes a battery pack provided with plural secondary batteries. The herein disclosed technique can be applied to the battery module that uses this kind of battery pack as the battery device.

Additionally, in a suitable aspect of the battery module disclosed herein, a control device includes a selecting circuit configured to arbitrarily select a reference battery from a plurality of the secondary batteries; and a measurement instruction circuit configured to instruct an increase amount measurer so as to measure an increase amount $L_\Delta$ of an excess electrolytic solution of a reference battery. By doing this, it is possible to easily control the charge current of the battery pack including the plural secondary batteries.

BRIEF DESCRIPTION OF THE DRAWINGS

FIG. 1 is a block diagram that shows a configuration of a battery module in accordance with one embodiment.
FIG. 2 is a perspective view that schematically shows an appearance of a battery device shown in FIG. 1.
FIG. 3 is a perspective view that schematically shows an appearance of a secondary battery shown in FIG. 2.
FIG. 4 is a longitudinal cross section view that schematically shows an inside structure of the secondary battery shown in FIG. 3.
FIG. 5 is a flowchart that shows an outline of a processing step of a charge control of the battery module in accordance with one embodiment.
FIG. 6 is a flowchart for explaining an example of an increase amount measuring step.
FIG. 7 is an example of an X-ray transmission image of the secondary battery.
FIG. 8 is a line profile that shows a change in luminance on a measurement line $M_L$ shown in FIG. 7.
FIG. 9 is a graph that shows a relation between an increase amount $L_\Delta$(%) of the excess electrolytic solution and a resistance increasing rate(%).
FIG. 10 is a flowchart that shows an outline of the processing step of the charge control of the battery module in accordance with another embodiment.

DETAILED DESCRIPTION

<First embodiment>

Below, one embodiment of a herein disclosed technique will be described in detail, by reference to the accompanying drawings. Incidentally, the matters other than matters particularly mentioned in this specification, and required for practicing the herein disclosed technique can be grasped as design matters of those skilled in the art based on the related art in the present field. The herein disclosed technique can be executed based on the contents disclosed in the present specification, and the technical common sense in the present field. Additionally, in the following drawings, it will be explained while the members/parts providing the same effect are provided with the same numerals and signs. Furthermore, the dimensional relation (such as length, width, and thickness) in each drawing does not reflect the actual dimensional relation.

1. Main configuration of battery module

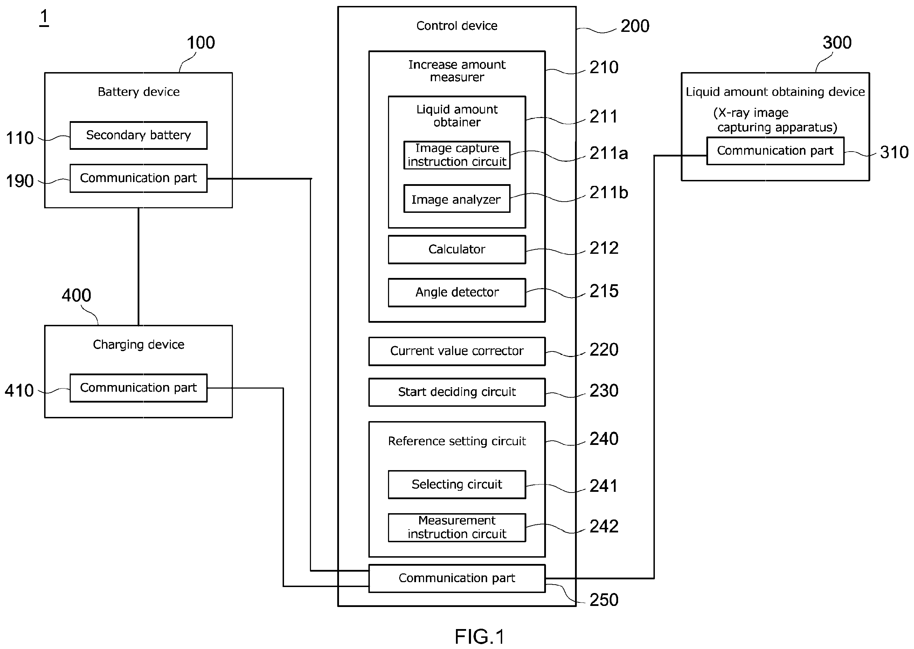

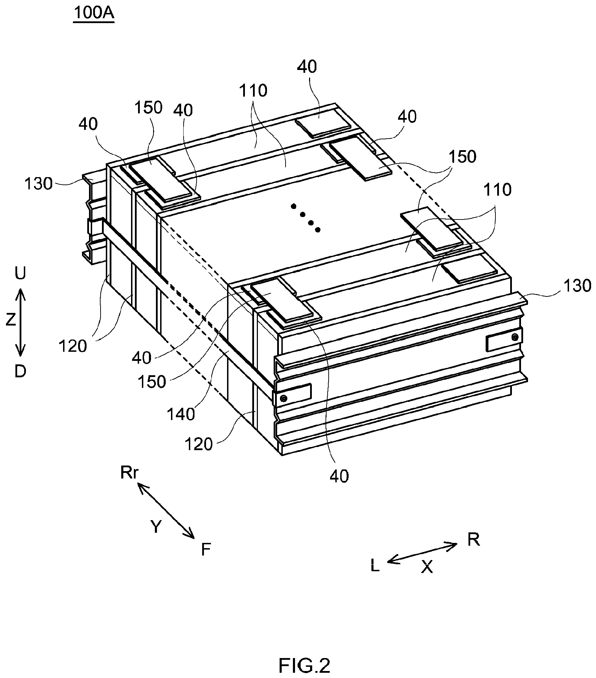

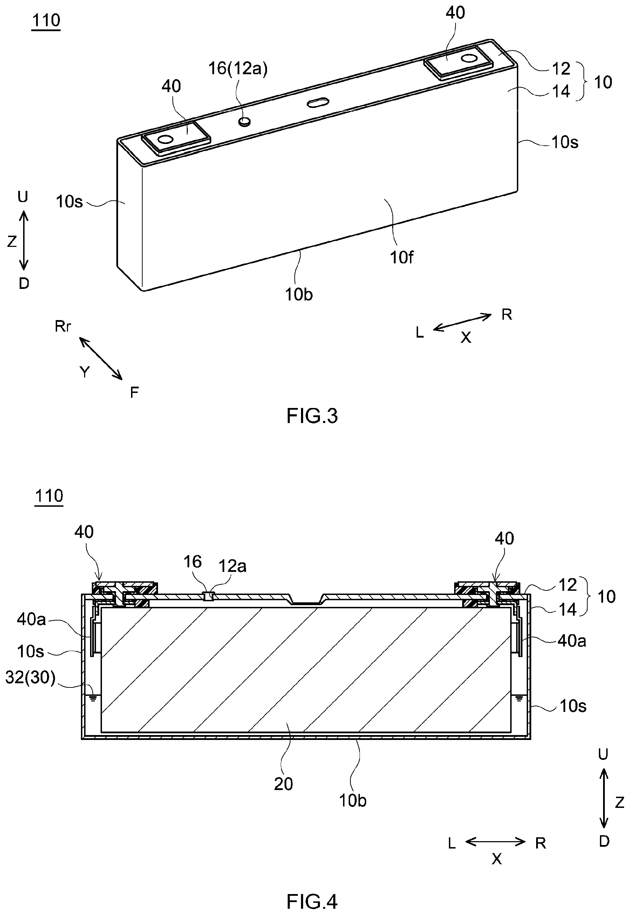

FIG. 1 is a block diagram that shows a configuration of a battery module in accordance with the present embodiment. FIG. 2 is a perspective view that schematically shows an appearance of a battery device shown in FIG. 1. FIG. 3 is a perspective view that schematically shows an appearance of a secondary battery shown in FIG. 2. FIG. 4 is a longitudinal cross section view that schematically shows an inside structure of the secondary battery shown in FIG. 3. Incidentally, in drawings explained by the present specification, a reference sign X represents a width direction, a reference sign Y represents a depth direction, and a reference sign Z represents a height direction. Furthermore, reference signs L, R, F, Rr, U, and D respectively represent leftward, rightward, frontward, rearward, upward, and downward. However, these directions are defined for convenience sake of explanation, and they are not intended to restrict an use aspect of the secondary battery after it is manufactured.

As shown in FIG. 1, the battery module 1 in accordance with the present embodiment includes the battery device 100 and a control device 200. Furthermore, the battery module 1 in accordance with the present embodiment is provided with a liquid amount obtaining device 300. Below, each will be described.

(1) Battery device

As shown in FIG. 1, the battery device 100 in the present embodiment includes a secondary battery 110. As an example of this battery device 100, it is possible to apply a configuration that includes a battery pack 100A having a configuration shown by FIG. 2. This battery pack 100A includes plural secondary batteries 110. Respective secondary batteries 110 are arranged to make flat surfaces 10f of battery cases 10 described later (see FIG. 3) be opposed mutually. In addition, between adjacent 2 secondary batteries 110, a spacer 120 is arranged. Then, these plural secondary batteries 110 are sandwiched by a pair of restriction plates 130. The pair of restriction plates 130 are connected by a cross-linking member 140 extending along an arrangement direction (depth direction Y in FIG. 2). The restriction plates 130 and the cross-linking member 140 restrict each of the secondary batteries 110 with a predetermined restriction pressure. In addition, the battery pack 100A shown in FIG. 2 includes a connecting member 150 that is configured to electrically connect each of the plural secondary batteries 110. This connecting member 150 is configured to connect electrode terminals 40 of the adjacent secondary batteries 110. By doing this, it is possible to use the plural secondary batteries 110 as one battery device 100. In addition, as shown in FIG. 1, the battery device 100 in the present embodiment includes a communication part 190. This communication part 190 is configured to be able to communicate with another equipment (for example, control device 200). Incidentally, a communication method performed by "communication part" of the present specification might be a wire communication or a wireless communication.

Next, an example of a structure of the secondary battery 110 in the battery device 100 will be explained. As shown in FIG. 3 and FIG. 4, this secondary battery 110 is configured by accommodating an electrode body 20 and an electrolytic solution 30 inside a battery case 10.

(1-a) Battery case

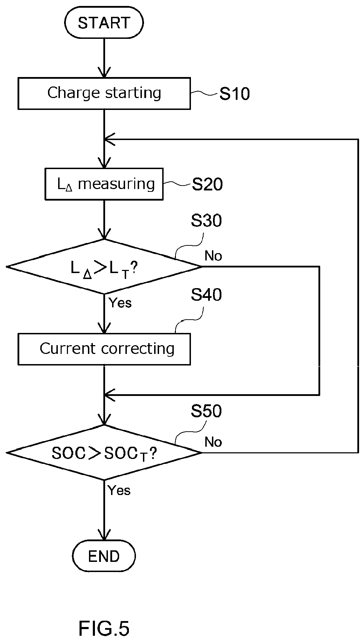

The battery case 10 is a container being formed in a box shape and having an internal space. In the internal space of this battery case 10, the electrode body 20 and the electrolytic solution 30 are accommodated. Incidentally, the battery case 10 shown in FIG. 3 and FIG. 4 is a container formed in a flat rectangular parallelepiped shape. In particular, the battery case 10 includes a case main body 14 being a box-shaped member having an upper surface opening, and includes a sealing plate 12 being a plate-shaped member configured to cover the upper surface opening of this case main body 14. Incidentally, in a case where an X-ray transmission image is obtained at the later-described increase amount measuring step (S20 in FIG. 5), it is preferable that the battery case 10 is formed with aluminum (which semantically includes aluminum alloy), resin, or the like. The battery case 10 formed with these materials has an X-ray transmission rate being higher, and thus it is possible at the increase amount measuring step S20 to obtain a sharp X-ray transmission image.

In addition, the sealing plate 12 is provided with a liquid injection hole 12a configured to inject the electrolytic solution 30 to an inside of the battery case 10.

Incidentally, this liquid injection hole 12a is sealed by a sealing member 16, after the electrolytic solution 30 is injected. Furthermore, to the sealing plate 12, a pair of electrode terminals 40 are attached. Each of the electrode terminals 40 is a structure body in which plural conductive members are combined, and which is configured to extend along a height direction Z. Then, an electrical collector member 40a configuring a lower end part of the electrode terminal 40 is connected to the electrode body 20 at the inside of the battery case 10.

(1-b) Electrode body

The electrode body 20 is a member in which a positive electrode and a negative electrode are opposed via a separator. As an example of the structure of the electrode body 20 described above, it is possible to use a wound electrode body, a laminate type electrode body, or the like. The wound electrode body is formed by winding a laminated body made by laminating the positive electrode formed in a long sheet shape, the negative electrode formed in a long sheet shape, and the separator formed in a long sheet shape. On the other hand, the laminate type electrode body is formed by alternately laminating a short positive electrode and a short negative electrode. In the laminate type electrode body, the separators are dispose at a gap between each electrodes. Incidentally, regarding a configuration member (positive electrode, negative electrode, separator, or the like) of the electrode body 20, it is possible without particular restriction to use materials capable of being utilized in a general secondary battery, which does not restrict the herein disclosed technique, and thus a detailed explanation is omitted.

(1-c) Electrolytic solution

The electrolytic solution 30 is an electrolyte in liquid form that can make a charge carrier move between the positive electrode and the negative electrode. The most portion of the electrolytic solution 30 is osmosed to the inside of the electrode body 20 (electrode gap between the positive electrode and the negative electrode). Additionally, in the present embodiment, there is an excess electrolytic solution 32 at an outside of the electrode body 20 (between the electrode body 20 and the battery case 10). The excess electrolytic solution 32 is not osmosed to the inside of the electrode body 20. When a shortage of the electrolytic solution 30 inside the electrode body 20 is caused, the excess electrolytic solution 32 (the electrolytic solution 30) can be supplied to the inside of this electrode body 20. Incidentally, regarding the electrolytic solution 30, it is also possible to use one capable of being utilized in the general secondary battery without particular restriction.

(2) Control device

The control device 200 is an equipment configured to control a charge and discharge of the battery device 100. This control device 200 is a computer that includes a controller (for example, CPU) configured to manage various controls and includes a storage part configured to store program, data, or the like. Incidentally, the control device 200 might serve even as a control part configured to manage a control of an external equipment (vehicle, portable terminal, or the like). However, a configuration as a hardware of the control device 200 is not to restrict the herein disclosed technique. In other words, it is enough for the control device 200 to be configured in a manner capable of performing a current correcting control described later.

Here, the control device 200 in the present embodiment includes an increase amount measurer 210 configured to measure a increase amount $L_\Delta$ of the excess electrolytic solution of the secondary battery 110 during a charge, and includes a current value corrector 220 configured to perform a current correcting control in which a current value of a charge current with respect to the battery device 100 is corrected on a basis of the increase amount $L_\Delta$ of the excess electrolytic solution. Furthermore, the control device 200 includes a start deciding circuit 230 configured to instruct the current value corrector 220 to start the current correcting control when the increase amount $L_\Delta$ of the excess electrolytic solution exceeds a predetermined threshold $L_T$, and includes a communication part 250 configured to be in a manner capable of communicating with another equipment (for example, battery device 100). Incidentally, a content of a detailed processing performed by each members included in the control device 200 will be described later.

(3) Liquid amount obtaining device

The liquid amount obtaining device 300 is an equipment configured to measure a liquid amount of the excess electrolytic solution 32 of the secondary battery 110. In the present embodiment, the liquid amount obtaining device 300 is an X-ray image capturing apparatus configured to capture an X-ray transmission image of the secondary battery 110. In addition, the battery device 100 in the present embodiment includes an isolated secondary battery (battery for capturing images) that is not included in the battery pack 100A shown by FIG. 2. This battery for capturing images has a configuration the same as the secondary battery 110 included in the battery pack 100A, and is electrically connected to the battery pack 100A. In addition, onto the battery for capturing images, a restriction pressure approximately equal to the secondary battery 110 included in the battery pack 100A is applied. In other words, regarding the battery for capturing images, a charge and discharge is performed under the same condition as the secondary battery 110 included in the battery pack 100A, except for being arranged at an outside of the battery pack 100A. The X-ray image capturing apparatus 300 in the present embodiment is arranged at a position capable of obtaining the X-ray transmission image of this battery for capturing images. By doing this, it is possible to easily obtain the X-ray transmission image being sharp, even if the battery pack 100A is constructed in which the plural secondary batteries 110 are restricted. Additionally, as shown in FIG. 1, the liquid amount obtaining device 300 also includes a communication part 310 capable of communicating with another equipment (for example, control device 200).

(4) Charging device

In addition, as shown in FIG. 1, the battery device 100 is configured in a manner capable of being connected to the charging device 400. This charging device 400 is an equipment for supplying a charge current to the secondary battery 110 of the battery device 100. Incidentally, the charging device 400 might be mounted on the battery module 1 or might be an outside equipment capable of being connected to the battery device 100. For example, in a case where the herein disclosed technique is applied to a hybrid vehicle, an internal combustion engine, a motor generator, a DC-DC converter, or parts including control devices of them in the hybrid vehicle can function as the charging device 400. In that case, the charging device 400 is in a state of being always connected to the battery device 100, and thus it is possible to switch a charging state and a non-charging state, by switching with a switching operation performed by the control device, or the like. On the other hand, in a case where the herein disclosed technique is applied to an electric vehicle, a portable terminal, or the like, an external charge apparatus functions as the charging device 400. In that case, the charging device (external charge apparatus) 400 is electrically connected to the battery device 100 or the control device 200 when charging the battery device 100. In addition, as shown in FIG. 1, the charging device 400 also includes a communication part 410 capable of communicating with another equipment (for example, control device 200).

2. Processing step of charge control

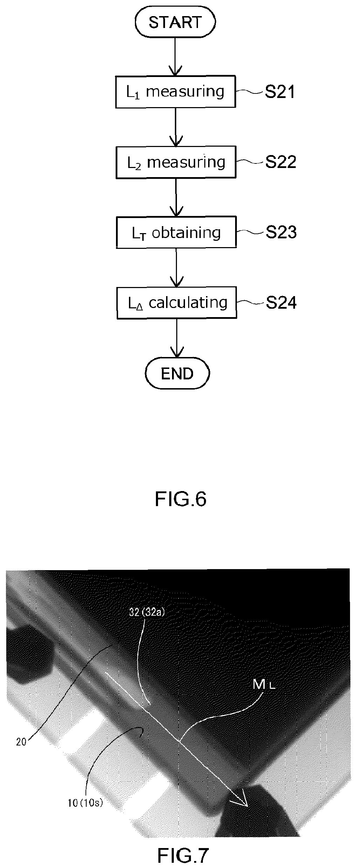

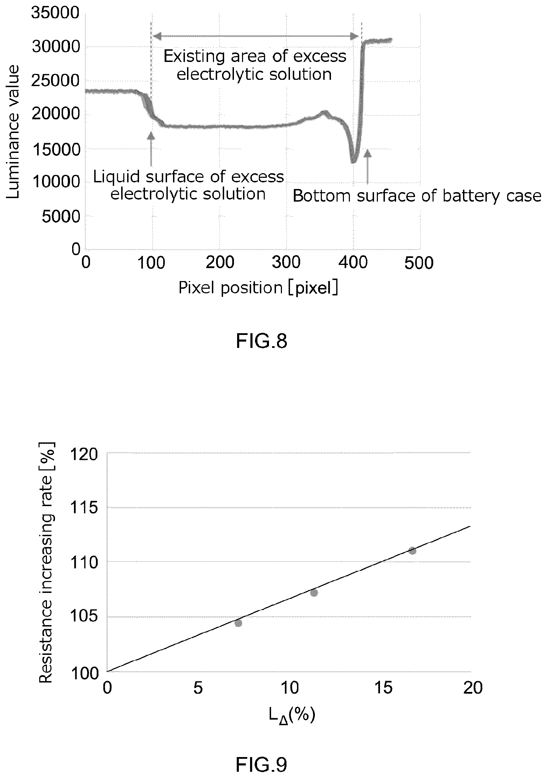

Below, a processing step of a charge control performed in the battery module 1 in accordance with the present embodiment will be described. FIG. 5 is a flowchart that shows an outline of the processing step of the charge control of the battery module in accordance with the present embodiment. FIG. 6 is a flowchart for explaining an example of an increase amount measuring step. FIG. 7 is an example of the X-ray transmission image of the secondary battery. FIG. 8 is a line profile that shows a change in luminance on a measurement line $M_L$ of FIG. 7. FIG. 9 is a graph that shows a relation between an increase amount $L_A$(%) of the excess electrolytic solution and a resistance increasing rate(%).

As shown in FIG. 5, the processing step of the charge control in the present embodiment includes a charge starting step S10, an increase amount measuring step S20, an increase amount judging step S30 for the excess electrolytic solution, and a current value correcting step S40. Furthermore, in the present embodiment, a SOC judging step S50 is provided after the current value correcting step S40. Below, each of the steps will be described.

(1) Charge starting step S10

At the present step, a charge on the battery device 100 is started. Incidentally, a detailed charge condition is to be suitably set according to a size or a material of the secondary battery 110, and is not an element restricting the herein disclosed technique. Thus, a detailed explanation of the charge condition is omitted in this specification. In addition, the charge control in the present embodiment might be performed all the time, or might be performed only during a rapid charge (high rate charge). A high rate deterioration tends to be caused particularly during the rapid charge, and thus by performing the charge control of the present embodiment only in this situation, it becomes easy to suppress the high rate deterioration while maintaining a charge efficiency.

(2) Increase amount measuring step S20

At the present step, by the increase amount measurer 210 for the excess electrolytic solution, the increase amount $L_A$ of the excess electrolytic solution of the secondary battery 110 during the charge is measured. This wording "increase amount $L_A$ of the excess electrolytic solution" represents an amount of the electrolytic solution 30 having flown out to the outside of the electrode body 20 due to an expansion of the electrode for the charge. In other words, it is possible to consider that, when the increase amount $L_A$ of the excess electrolytic solution becomes larger, the high rate deterioration of the secondary battery 110 is progressing further. On the other hand, it is possible to consider that, when the increase amount $L_A$ of the excess electrolytic solution is in a state of being smaller, the high rate deterioration does not progress.

Below, an example of a measurement procedure for "increase amount $L_A$ of the excess electrolytic solution" at the increase amount measuring step S20 will be explained. As shown in FIG. 1, the increase amount measurer 210 in the present embodiment includes a liquid amount obtainer 211 and a calculator 212. As shown in FIG. 6, the increase amount measurer 210 performs a $L_1$ measuring step S21, a $L_2$ measuring step S22, a $L_T$ obtaining step S23, and a $L_A$ calculating step S24, by the cooperation of the liquid amount obtainer 211 and the calculator 212.

(2-a) $L_1$ measuring step S21

At the present step, the liquid amount obtainer 211 measures a first liquid amount $L_1$. The term "first liquid amount Li" measured herein is corresponding to a liquid amount (ml) of the excess electrolytic solution at a first SOC previously determined. For example, the first SOC is set for a low SOC area in which the charge is required. For example, the first SOC is set within a range from 10% to 20% (for example, about 17%). In the low SOC area as described above, a flow-out of the electrolytic solution 30 due to an expansion of the electrode is caused little. Thus, in the present embodiment, the first liquid amount $L_1$ is treated as a reference. And, a difference between the reference (the first liquid amount Li) and a second liquid amount $L_2$ described later is calculated. As a result, it is possible to further accurately measure the flow-out of the electrolytic solution 30 (high rate deterioration) according to the progress of the charge.

Incidentally, it is preferable that "liquid amount (ml) of the excess electrolytic solution" is measured on the basis of an image analysis on an X-ray transmission image of the secondary battery 110. By doing this, it is possible to accurately measure an actual liquid amount of the excess electrolytic solution 32. In order to perform the image analysis of the X-ray transmission image described above, the liquid amount obtainer 211 in the present embodiment includes an image capture instruction circuit 211a and an image analyzer 211b. Below, it will be particularly explained about measurement of the liquid amount of the excess electrolytic solution with the X-ray transmission image.

At first, the image capture instruction circuit 211a instructs the X-ray image capturing apparatus 300 via the communication part 250 to capture the X-ray transmission image. Then, the X-ray image capturing apparatus 300 obtains the X-ray transmission image of the secondary battery 110 in response to the instruction. Incidentally, it is preferable that a capturing condition for the X-ray transmission image is suitably adjusted to be a condition in which a liquid surface 32a of the excess electrolytic solution 32 can be accurately recognized. As an example, it is preferable that a pipe voltage of at the image capturing time is set to be within a range from 125 kV to 175 kV (for example, 150 kV). In addition, it is preferable that a pipe current is set to be within a range from 175 μA to 225 μA (for example, 200 μA). Then, the X-ray image capturing apparatus 300 transmits the captured X-ray transmission image to the image analyzer 211b of the control device 200 via the communication part 310.

Incidentally, there is a case where the liquid surface 32a of the excess electrolytic solution 32 is hardly recognized when the secondary battery 110 (battery cell) is in a horizontal posture with respect to the ground. At that case, it is preferable that the X-ray transmission image is captured in a state where the secondary battery 110 is tilted. At this case, the excess electrolytic solution 32 is gathered at a corner of the battery case 10 downward in a gravity direction, and thus it becomes comparatively easy to recognize the liquid surface 32a of the excess electrolytic solution 32 as shown in FIG. 7. For example, in a case where the battery device 100 is mounted on an automobile, it is preferable to mount a device for tilting the posture of the battery device 100 (for example, only the battery for capturing images) with respect to the vehicle. By doing this, it is possible to accurately recognize the liquid surface 32a of the excess electrolytic solution 32 while the battery device 100 (secondary battery 110) is tilted during the vehicle's travel. Additionally, in a case where the charging device 400 is the external charge apparatus, it is preferable to attach an apparatus, which is for tilting the posture of the battery device 100, onto the external charge apparatus.

Next, the image analyzer 211b measures the liquid amount of the excess electrolytic solution based on the image analysis of the X-ray transmission image. Below, an example of the procedure for analyzing the X-ray transmission image will be explained, while referring to FIG. 7. The image analyzer 211b, at first, sets a measurement line $M_L$ extending along a side surface 10s of the battery case 10 on an area between the electrode body 20 and the battery case 10 of the captured X-ray transmission image. Then, a predetermined image analyzing software (Image-J, or the like) is used to analyze a change in luminance along the measurement line $M_L$. For example, regarding an analysis result shown by FIG. 8, a luminance value is drastically reduced near 100 pixel. This is because the X-ray transmission rate on an area where the excess electrolytic solution 32 exists is low. Based on this matter, the image analyzer 211b considers that the liquid surface 32a of the excess electrolytic solution 32 exists at a position near 100 pixel. Next, regarding FIG. 8, the luminance value is further reduced at a position near 400 pixel. This is because it reaches the bottom surface 10b of the battery case 10 whose X-ray transmission property is little. Based on this matter, the image analyzer 211b considers that the excess electrolytic solution 32 exists on an area of 100 to 400 pixel. Then, the image analyzer 211b in the present embodiment stores a relational expression formula between "existing area (pixel) of the excess electrolytic solution 32 on the X-ray transmission image" and "actual liquid amount (ml) of the excess electrolytic solution". The relational expression formula is set based on results of a preliminary test. The image analyzer 211b calculates a liquid amount (ml) of the excess electrolytic solution from "existing area of the excess electrolytic solution" in FIG. 8, based on this relational expression. Then, the image analyzer 211b transmits the calculated liquid amount of the excess electrolytic solution (first liquid amount $L_1$ at the present step) to the calculator 212.

(2-b) $L_2$ measuring step S22

Next, at the present step, the liquid amount obtainer 211 measures the second liquid amount $L_2$. The term "second liquid amount $L_2$" measured here is corresponding to a liquid amount of the excess electrolytic solution with a second SOC which is a higher SOC than the first SOC. For example, the second SOC is set on a high SOC area in which the charge of the secondary battery 110 has been progressed to some extent. By doing this, it is possible to treat the liquid amount of the excess electrolytic solution in a state where the charge has been sufficiently progressed as the "second liquid amount $L_2$", and thus it is possible to further accurately evaluate an extent of the high rate deterioration of the secondary battery 110. In addition, to make the second liquid amount $L_2$ be measured on each occasion that the SOC rises by a certain amount with the first SOC treated as a starting point, plural second SOCs might be set on the liquid amount obtainer 211. By doing this, it is possible to further precisely perform the current correcting control in correspondence with the progress of the high rate deterioration.

Incidentally, the second liquid amount $L_2$ is measured by a procedure the same as the first liquid amount Li, except for a fact that the second liquid amount is measured on the higher SOC than the first SOC. In other words, the second liquid amount $L_2$ can be measured by the image analysis performed on the X-ray transmission image of the secondary battery 110. Regarding the measurement of the second liquid amount $L_2$ based on this X-ray transmission image, explanation here is omitted in order to avoid the overlapped explanation. Incidentally, the second liquid amount $L_2$ after the measurement is transmitted to the calculator 212, similarly to the first liquid amount $L_1$.

(2-c) $L_T$ obtaining step S23

At the present step, the liquid amount obtainer 211 obtains a total amount (total liquid amount $L_T$) of the electrolytic solution 30 existing in the battery case 10. Here, the term "total liquid amount $L_T$" is corresponding to a total amount in which the excess electrolytic solution 32 existing at an outside of the electrode body 20 and the electrolytic solution 30 osmosed to the inside of the electrode body 20 are added. By reflecting the total liquid amount $L_T$ at the later described $L_\Delta$ calculating step S24, it is possible to evaluate the high rate resistant property of the secondary battery 110, without being influenced by an injected liquid amount of the electrolytic solution 30. This total liquid amount $L_T$ is also transmitted from the liquid amount obtainer 211 to the calculator 212. Incidentally, the total liquid amount $L_T$ of the electrolytic solution 30 is previously stored in the storage part of the control device 200. It is possible as the total liquid amount $L_T$ of the electrolytic solution 30 to use a standard value at a battery design time, or to use an actual measurement value measured at the secondary battery 110 construction time (at the liquid injection time of the electrolytic solution 30).

(2-d) $L_\Delta$ calculating step S24

At the present step, the increase amount $L_\Delta$ of the excess electrolytic solution is calculated on the basis of each parameter obtained by the liquid amount obtainer 211. In particular, the calculator 212 substitutes the first liquid amount Li, the second liquid amount $L_2$, and the total liquid amount $L_T$, which are transmitted from the liquid amount obtainer 211, into the below described Formula (1), so as to calculate the increase amount $L_\Delta$ of the excess electrolytic solution. This increase amount $L_\Delta$ of the excess electrolytic solution is a value in which an amount ($L_2 - L_1$) of the electrolytic solution having flown out to an outside of the electrode body due to the expansion of the electrode during the charge is standardized by the total liquid amount $L_T$ of the electrolytic solution 30. Incidentally, the calculator 212 transmits the calculated increase amount $L_\Delta$ of the excess electrolytic solution to the start deciding circuit 230 and the current value corrector 220.

$$L_\Delta = (L_2 - L_1)/L_T \qquad (1)$$

(3) Increase amount judging step S30

At the present step, the start deciding circuit 230 performs the increase amount judging step S30 in which the increase amount $L_\Delta$ of the excess electrolytic solution and a predetermined threshold $L_T$ are subjected to a comparison judgment. Incidentally, the threshold $L_T$ of the present step can be suitably set according to a standard of the secondary battery being a manufacture target. For example, the threshold $L_T$ might be set to be within a range from 0.05% to 10%.

Then, when the increase amount $L_\Delta$ of the excess electrolytic solution exceeds the threshold $L_T$ (S30: in a case of YES), it is considered that a large amount of electrolytic solution 30 flows out from the electrode body 20. In this case, the start deciding circuit 230 judges that the high rate deterioration of the secondary battery 110 is progressing, and instructs the current value corrector 220 to start the current correcting control (S40). On the other hand, when the increase amount $L_\Delta$ of the excess electrolytic solution becomes equal to or less than the threshold $L_T$ (S30: in a case of NO), it is considered that the flow-out amount of the electrolytic solution 30 is small. In this case, the start deciding circuit 230 judges that the high rate deterioration of the secondary battery 110 is progressing little, and instructs the current value corrector 220 to continue the charge without performing the current correcting control.

(4) Increase amount judging step S30

At the present step, the current value corrector 220 corrects the current value of the charge current with respect to the battery device 100, based on the increase

amount $L_\Delta$ of the excess electrolytic solution. In particular, if the charge current having the higher current value is continuously supplied to the secondary battery 110 judged to have the progressing high rate deterioration (judged to be YES at S30), a further large amount of the electrolytic solution 30 flows out from the electrode body 20. In this case, there is a fear that a large deviation is caused on the distribution of the charge and discharge area inside the electrode body 20. The deviation causes a permanent degradation, in which the battery performance cannot be sufficiently recovered even if the electrolytic solution 30 flows in. Thus, the current value corrector 220 performs a correcting control to reduce the current value of the charge current with respect to the battery device 100. By doing this, it is possible, without stopping the charge current, to inhibit the progress of the high rate deterioration of the secondary battery 110.

Incidentally, a particular correcting condition at the present step can be suitably set according to the standard of the secondary battery or the external equipment, which is not to restrict the herein disclosed technique. For example, the current value corrector 220 might store 2 kinds of current values, "current value at the normal time" and "current value at the high rate deterioration time". The current value corrector 220 having a configuration described above uses "current value at the normal time" in a case of NO at the increase amount judging step S30 ($L_\Delta \leq L_T$), and uses "current value at the high rate deterioration time" in a case of YES($L_\Delta > L_T$). By doing this, it is possible to inhibit the progress of the high rate deterioration while suppressing the reduction in the charge efficiency. In addition, as another example, the current value corrector 220 might store a matrix form data base in which a relation between the increase amount $L_\Delta$ of the excess electrolytic solution and the current value is defined. The current value corrector 220 having the configuration described above can select an appropriate current value in the data base, based on the increase amount $L_\Delta$ of the excess electrolytic solution transmitted from the calculator 212.

(5) SOC judging step S50

Then, the control device 200 of the battery module 1 in accordance with the present embodiment performs the SOC judging step S50 at which a current SOC of the secondary battery and a predetermined charge completion $SOC_T$ are compared. Then, in a case where the current SOC is less than the charge completion $SOC_T$ (S50: NO), the control device 200 repeatedly performs the increase amount measuring step S20 and the increase amount judging step S30. By doing this, it is possible to continue charging the battery device 100 while suitably correcting the current value according to the progress situation of the high rate deterioration. On the other hand, in a case where the current SOC becomes equal to or more than the charge completion $SOC_T$ (S50: YES), the control device 200 judges that the charge is completed, and ends the charge control processing (END).

(6) Summary

As described above, the control device 200 of the battery module 1 in accordance with the present embodiment measures the increase amount $L_\Delta$ of the excess electrolytic solution during the charge. This increase amount $L_\Delta$ of the excess electrolytic solution represents an amount of the electrolytic solution 30 having flown out due to the expansion of the electrode during the charge. In other words, it is supposed in the secondary battery 110, whose increase amount $L_\Delta$ of the excess electrolytic solution is large, that a large amount of the electrolytic solution 30 are flowing out and the high rate deterioration is progressing. This is supported by experiments performed by the present inventor, too. In particular, as shown in FIG. 9, it is confirmed that, when the increase amount $L_\Delta$ of the excess electrolytic solution (%) during the charge becomes larger, the resistance increasing rate during the charge becomes higher. Then, the control device 200 of the battery module 1 in accordance with the present embodiment is provided with the current value corrector 220 that performs the current correcting control based on the increase amount $L_\Delta$ of the excess electrolytic solution. By doing this, the charge is continued while the current value is corrected according to the extent of the high rate deterioration, and thus it is possible to suppress the high rate deterioration and further to maintain the charge efficiency equal to or more than a certain level.

2. Another configuration of battery module

Above, a main configuration of the battery module 1 in accordance with the present embodiment has been explained. Incidentally, the battery module 1 in accordance with the present embodiment includes various configurations, in addition to the above described configuration, which enhance the effect induced by the herein disclosed technique. Below, these configurations will be described.

(1) Angle detector

As described above, it is preferable that the X-ray transmission image of the secondary battery 110 is an image in which the secondary battery 110 is under a state of being tilted, as shown in FIG. 7. By doing this, the excess electrolytic solution 32 is gathered at a portion downward in the height direction, and thus it is possible to perform an accurate measurement even in a case where the liquid amount of the excess electrolytic solution 32 is small. However, regarding the herein disclosed technique, a device for tilting the above described battery device 100 is not essential. For example, in a case where the battery device 100 is mounted on an automobile, the battery module 1 may include an angle detector 215. The angle detector 215 continues detecting a tilt angle $\theta$ of the secondary battery 110. And, when the secondary battery 110 is tilted by driving the automobile, the X-ray transmission image is captured. For example, in a case where the battery module 1 is mounted on a hybrid vehicle, it is possible to use the angle detector of the ECU (engine control unit) of the present vehicle, so as to detect the tilt angle $\theta$ of the secondary battery 110 during the travel. Then, the angle detector 215 transmits this tilt angle $\theta$ to the image capture instruction circuit 211a. Then, the image capture instruction circuit 211a instructs the X-ray image capturing apparatus 300 to capture the X-ray transmission image when the tilt angle $\theta$ exceeds a predetermined capture angle $\theta_T$ during the travel on a hill road or a left and right slope. By doing this, it is possible to easily obtain the X-ray transmission image in which the secondary battery 110 is tilted. Incidentally, although it is not intended to restrict the herein disclosed technique, the tilt angle $\theta$ suitable for capturing the X-ray transmission image is 30° to 60°, and thus it is preferable that the X-ray transmission image is captured when the tilt angle as described above has been secured.

(2) Reference setting circuit

Additionally, the battery device 100 in the present embodiment is a battery pack including plural secondary batteries 110. Regarding the battery module 1 including the battery pack as described above, it is preferable to select an arbitrary measurement target (reference battery) among the plural secondary batteries 110, so as to perform the current correcting control on the whole of the battery device 100 based on the increase amount $L_\Delta$ of the excess electrolytic solution of the reference battery. By doing this, it is possible to inhibit the current correcting control from becoming unnecessarily complicated. Particularly, as shown in FIG. 1, the control device 200 in the present embodiment includes a reference setting circuit 240 that sets the reference battery among the plural secondary batteries 110. Then, this reference setting circuit 240 includes a selecting circuit 241 that arbitrarily selects the reference battery from the plural secondary batteries 110, and includes a measurement instruction circuit 242 that instructs the increase amount measurer 210 to measure the increase amount $L_\Delta$ of the excess electrolytic solution of the reference battery. By doing this, it is possible while treating a desired secondary battery 110 as the reference battery to measure the increase amount $L_\Delta$ of the excess electrolytic solution of the reference battery. Incidentally, as described above, in a case where the battery for capturing images isolated from the battery pack 100A is provided, the selecting circuit 241 selects this battery for capturing images as the reference battery. By doing this, it is possible to always obtain the clear X-ray transmission image. Incidentally, the number of the reference batteries is not particularly restricted. For example, in a case where the selecting circuit 241 has selected plural reference batteries, it is good that the increase amount measurer 210 obtains the increase amounts $L_\Delta$ of the plural excess electrolytic solutions so as to transmit the maximum value of them to the start deciding circuit 230. By doing this, the current correcting control is performed on the basis of the secondary battery 110 whose high rate deterioration is progressed the most, and thus it is possible to properly suppress the progress of the high rate deterioration.

<Another embodiment>

Above, an embodiment of the herein disclosed battery module has been explained. Incidentally, the herein disclosed battery module is not restricted to the above described embodiment, and various matters can be changed suitably. Below, an example of the matter capable of being changed from the above described embodiment will be described.

1. Presence or absence of start deciding circuit

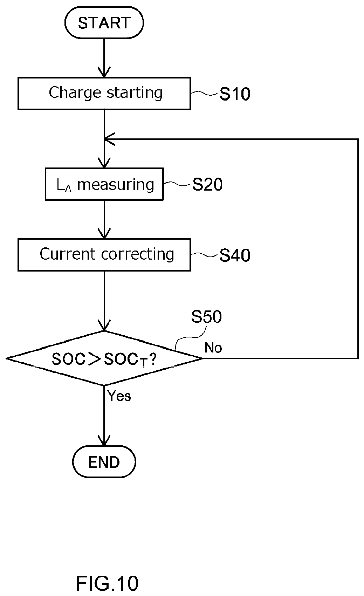

The battery module in accordance with the above described embodiment includes the start deciding circuit 230 that compares the increase amount $L_\Delta$ of the excess electrolytic solution during the charge and the threshold $L_T$ so as to decide a necessity of the current correcting control. However, the herein disclosed battery module might not include the start deciding circuit 230. For example, in a flowchart shown by FIG. 10, a processing corresponding to the increase amount judging step S30 of FIG. 5 is not performed. In this flowchart, the current correcting control based on the increase amount $L_\Delta$ of the excess electrolytic solution is always performed. Even in a case where the configuration described above is applied, the charge can be continued while the current value is corrected according to the extent of the high rate deterioration, and thus it is possible to properly suppress the progress of the high rate deterioration so as to maintain the charge efficiency equal to or more than a certain level. However, the battery module having the configuration described above performs the current correcting control, even in a situation where the high rate deterioration is caused little, so as to decrease the current value of the charge current. In consideration of the reduction in the charge efficiency due to this operation, as shown in the above described embodiment, it is preferable that the control step should be constructed not to perform the current correcting control until the increase amount $L_\Delta$ of the excess electrolytic solution exceeds the threshold $L_T$.

2. Measuring for increase amount $L_\Delta$ of excess electrolytic solution

In the above described embodiment, the liquid amount (first liquid amount Li, and second liquid amount $L_2$) of the excess electrolytic solution is measured on the basis of the image analysis on the X-ray transmission image. And the increase amount $L_\Delta$ of the excess electrolytic solution is calculated on the basis of the measurement result. However, the method for measuring the liquid amount of the excess electrolytic solution is not restricted to the image analysis on the X-ray transmission image. The herein disclosed technique can use a method conventionally known for grasping the liquid amount of the excess electrolytic solution in the battery case, without particular restriction. For example, the liquid amount of the excess electrolytic solution can be measured by using a voltage value at a full-charged time, a change amount in the voltage for the charge and discharge, or the like. A method for using the voltage value at the full-charged time is disclosed in Japanese Patent Application Publication No. 2022-44621. In addition, a method for using the change amount in the voltage for the charge and discharge is disclosed in Japanese Patent Application Publication No. 2021-182474. In addition, Japanese Patent Application Publication No. 2021-170436 discloses a method for measuring the liquid amount of the excess electrolytic solution, on the basis of the image analysis performed on an ultrasonic image of the secondary battery. For the image analysis on the ultrasonic image at that time, similarly to the image analysis on the X-ray transmission image described above, it is possible to use a method based on a luminance analysis on the image. The increase amount measurer of the herein disclosed battery module includes an increase amount measurer that uses the above described measuring technique to measure the increase amount $L_\Delta$ of the excess electrolytic solution during the charge. However, the liquid amount of the excess electrolytic solution based on the voltage value is a so-called estimated value, and thus might be different from the actual liquid amount of the excess electrolytic solution. Accordingly, in consideration of the precision property of the measurement result, it is preferable to use a method capable of directly measuring the liquid amount of the excess electrolytic solution (image analysis on the X-ray transmission image or the ultrasonic image, or the like).

Above, the embodiments of the herein disclosed technique have been explained. However, the above described explanation is merely an illustration, and is not to restrict the scope of claims. The technique recited in the scope of claims includes contents in which the specific examples illustrated in the above explanation are variously deformed or changed.

In other words, the herein disclosed technique contains contents of [Item 1] to [Item 10] described below.

[Item 1]

A battery module, comprising:

a battery device that comprises a secondary battery in which an electrode body and an electrolytic solution are accommodated inside a battery case; and

a control device that is configured to control a charge and discharge of the battery device, wherein

the control device comprises:

an increase amount measurer that is configured to measure an increase amount $L_\Delta$ of an excess electrolytic solution of the secondary battery for a charge; and
a current value corrector that is configured to perform a current correcting control for correcting a current value of a charge current with respect to the battery device, based on the increase amount $L_\Delta$ of the excess electrolytic solution.

[Item 2]

The battery module recited in item 1, wherein the control device further comprises a start deciding circuit that is configured to instruct the current value corrector to start the current correcting control when the increase amount $L_\Delta$ of the excess electrolytic solution exceeds a predetermined threshold $L_T$.

[Item 3]

The battery module recited in item 1 or 2, wherein
the increase amount measurer comprises:

a liquid amount obtainer that is configured to obtain a first liquid amount $L_1$ corresponding to a liquid amount of the excess electrolytic solution with a predetermined first SOC, a second liquid amount $L_2$ corresponding to a liquid amount of the excess electrolytic solution with a second SOC being a higher SOC than the first SOC, and a total liquid amount $L_T$ corresponding to a total amount of the electrolytic solution existing inside the battery case; and
a calculator that is configured to calculate the increase amount $L_\Delta$ of the excess electrolytic solution based on a following Formula (1).

$$L_\Delta = (L_2 - L_1)/L_T \qquad (1)$$

[Item 4]

The battery module recited in item 3, wherein the first SOC is set within a range from 10% to 20%.

[Item 5]

The battery module recited in item 3 or item 4, further comprising:
an X-ray image capturing apparatus that is configured to capture an X-ray transmission image of the secondary battery, wherein the liquid amount obtainer comprises:

an image capture instruction circuit that is configured to instruct the X-ray image capturing apparatus so as to capture the X-ray transmission image; and
an image analyzer that is configured to measure a liquid amount of the excess electrolytic solution based on an image analysis for the X-ray transmission image.

[Item 6]

The battery module recited in item 5, wherein

the image analyzer is configured to set a measurement line along a side surface of the battery case on an area between the electrode body and the battery case, and
the image analyzer is configured to analyze changes of luminance on the measurement line, so as to measure the liquid amount of the excess electrolytic solution.

[Item 7]

The battery module recited in item 5 or 6, wherein

the increase amount measurer further comprises an angle detector that is configured to detect a tilt angle $\theta$ of the secondary battery, and
the image capture instruction circuit instructs the X-ray image capturing apparatus to capture the X-ray transmission image when the tilt angle $\theta$ exceeds a predetermined capture angle $\theta_T$.

[Item 8]

The battery module recited in any one of items 5 to 7, wherein
the battery case is formed with aluminum or resin.

[Item 9]

The battery module recited in any one of items 1 to 8, wherein
the battery device comprises a battery pack provided with plural said secondary batteries.

[Item 10]

The battery module recited in item 9, wherein the control device comprises:

a selecting circuit that is configured to arbitrarily select a reference battery from a plurality of the secondary batteries; and
a measurement instruction circuit that is configured to instruct the increase amount measurer so as to measure the increase amount $L_\Delta$ of the excess elec-

trolytic solution of the reference battery.

**Claims**

1. A battery module (1), comprising

a battery device (100) that comprises a secondary battery (110) in which an electrode body (20) and an electrolytic solution (30) are accommodated inside a battery case (10); and
a control device (200) that is configured to control a charge and discharge of the battery device (100), wherein

the control device (200) comprises:

an increase amount measurer (210) that is configured to measure an increase amount $L_\Delta$ of an excess electrolytic solution (32) of the secondary battery (110) for a charge; and
a current value corrector (220) that is configured to perform a current correcting control for correcting a current value of a charge current with respect to the battery device (100), based on the increase amount $L_\Delta$ of the excess electrolytic solution (32).

2. The battery module (1) according to claim 1, wherein the control device (200) further comprises a start deciding circuit (230) that is configured to instruct the current value corrector to start the current correcting control when the increase amount $L_\Delta$ of the excess electrolytic solution (32) exceeds a predetermined threshold LT.

3. The battery module (1) according to claim 1 or 2, wherein
the increase amount measurer (210) comprises:

a liquid amount obtainer (211) that is configured to obtain a first liquid amount L1 corresponding to a liquid amount of the excess electrolytic solution with a predetermined first SOC, a second liquid amount L2 corresponding to a liquid amount of the excess electrolytic solution with a second SOC being a higher SOC than the first SOC, and a total liquid amount LT corresponding to a total amount of the electrolytic solution existing inside the battery case; and
a calculator (212) that is configured to calculate the increase amount $L_\Delta$ of the excess electrolytic solution based on a following Formula (1).

$$L\Delta = (L2 - L1)/LT \qquad (1)$$

4. The battery module (1) according to claim 3, wherein

the first SOC is set within a range from 10% to 20%.

5. The battery module (1) according to claim 3 or 4, further comprising:
an X-ray image capturing apparatus (300) that is configured to capture an X-ray transmission image of the secondary battery (110), wherein
the liquid amount obtainer (211) comprises:

an image capture instruction circuit (211a) that is configured to instruct the X-ray image capturing apparatus (300) so as to capture the X-ray transmission image; and
an image analyzer (211b) that is configured to measure a liquid amount of the excess electrolytic solution based on an image analysis for the X-ray transmission image.

6. The battery module (1) according to claim 5, wherein

the image analyzer (211b) is configured to set a measurement line (ML) along a side surface of the battery case (10) on an area between the electrode body (20) and the battery case (10), and
the image analyzer (211b) is configured to analyze changes of luminance on the measurement line (ML), so as to measure the liquid amount of the excess electrolytic solution (32).

7. The battery module (1) according to claim 5 or 6, wherein

the increase amount measurer (210) further comprises an angle detector (215) that is configured to detect a tilt angle $\theta$ of the secondary battery (110), and
the image capture instruction circuit (211a) instructs the X-ray image capturing apparatus (300) to capture the X-ray transmission image when the tilt angle $\theta$ exceeds a predetermined capture angle $\theta T$.

8. The battery module (1) according to any one of claims 5 to 7, wherein
the battery case (10) is formed with aluminum or resin.

9. The battery module (1) according to any one of claims 1 to 8, wherein
the battery device (100) comprises a battery pack provided with plural said secondary batteries (110).

10. The battery module (1) according to claim 9, wherein the control device (200) comprises:

a selecting circuit (241) that is configured to arbitrarily select a reference battery from a plurality of the secondary batteries (110); and
a measurement instruction circuit (242) that is configured to instruct the increase amount measurer (210) so as to measure the increase amount $L\Delta$ of the excess electrolytic solution (32) of the reference battery.

FIG.1

100A

FIG.2

FIG.3

FIG.4

START

Charge starting — S10

$L_\Delta$ measuring — S20

S30

$L_\Delta > L_T$?    No

Yes

S40

Current correcting

S50

SOC > SOC$_T$?    No

Yes

END

FIG.5

FIG.6

FIG.7

FIG.8

FIG.9

START

Charge starting — S10

$L_\Delta$ measuring — S20

Current correcting — S40

S50

SOC > SOC$_T$? — No

Yes

END

FIG.10

Europäisches Patentamt
European Patent Office
Office européen des brevets

# EUROPEAN SEARCH REPORT

Application Number

EP 23 20 9054

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/005373 A1 (TASHIRO HIROKI [JP]) 5 January 2017 (2017-01-05) | 1-10 | INV. H01M10/48 |
| Y | * page 2, paragraph 0033 – page 11, paragraph 0129; figures 1-17 * | 4-10 | H01M10/44 H01M50/209 H01M50/569 |
| X | US 2010/204861 A1 (KAITA KEIJI [JP] ET AL) 12 August 2010 (2010-08-12) | 1-10 | G01R31/387 G01R31/392 |
| Y | * page 2, paragraph 0016 – page 14, paragraph 0196; figures 1-19 * | 4-10 | G01R31/396 |
| X | JP 2021 182474 A (NISSAN MOTOR; RENAULT SAS) 25 November 2021 (2021-11-25) | 1-10 | ADD. H01M50/204 H01M10/42 |
| Y | * page 2, paragraph 0009 – page 13, paragraph 0076; figures 1-10 * | 4-10 | |
| X | JP 2021 170436 A (TOYOTA MOTOR CORP) 28 October 2021 (2021-10-28) | 1-10 | |
| Y | * page 2, paragraph 0009 – page 8, paragraph 0060; figures 4-13 * | 4-10 | |

TECHNICAL FIELDS
SEARCHED (IPC)

H01M
G01R

The present search report has been drawn up for all claims

| Place of search | Date of completion of the search | Examiner |
|---|---|---|
| Munich | 19 April 2024 | Polisski, Sergej |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 9054

This annex lists the patent family members relating to the patent documents cited in the above-mentioned European search report.
The members are as contained in the European Patent Office EDP file on
The European Patent Office is in no way liable for these particulars which are merely given for the purpose of information.

19-04-2024

| Patent document cited in search report | | Publication date | Patent family member(s) | | Publication date |
|---|---|---|---|---|---|
| US 2017005373 A1 | | 05-01-2017 | CN | 106104905 A | 09-11-2016 |
| | | | DE | 112014006020 T5 | 20-10-2016 |
| | | | JP | 6102734 B2 | 29-03-2017 |
| | | | JP | 2015127991 A | 09-07-2015 |
| | | | US | 2017005373 A1 | 05-01-2017 |
| | | | WO | 2015097516 A1 | 02-07-2015 |
| US 2010204861 A1 | | 12-08-2010 | CN | 101828296 A | 08-09-2010 |
| | | | EP | 2204872 A1 | 07-07-2010 |
| | | | JP | 5210591 B2 | 12-06-2013 |
| | | | JP | 2009100513 A | 07-05-2009 |
| | | | US | 2010204861 A1 | 12-08-2010 |
| | | | WO | 2009050989 A1 | 23-04-2009 |
| JP 2021182474 A | | 25-11-2021 | JP | 7455655 B2 | 26-03-2024 |
| | | | JP | 2021182474 A | 25-11-2021 |
| JP 2021170436 A | | 28-10-2021 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021180122 A
- JP 2022044621 A
- JP 2021182474 A
- JP 2021170436 A